# EUROPÄISCHE PATENTSCHRIFT

(11) **EP 2 209 202 B1**
(45) Veröffentlichungstag und Bekanntmachung des Hinweises auf die Patenterteilung: **24.08.2011**
(21) Anmeldenummer: 10161853.6
(22) Anmeldetag: 12.06.2002
(51) Int. Cl.: H02N 2/02, H01L 41/09, H01L 41/04

(54) **Verfahren zum Betreiben eines Piezolinearantriebes mit einer Gruppe von Piezostapelaktoren**
Method for operating a piezo linear drive with a group of piezo stack actuators
Procédé de fonctionnement d'un entraînement piézo-linéaire doté d'un groupe de piézo-actionneurs

(30) Priorität: 12.06.2001 DE 10128497; 28.09.2001 DE 10148267; 22.05.2002 DE 10222592
(43) Veröffentlichungstag der Anmeldung: 21.07.2010
(62) Teilanmeldung aus: 02013412.8
(73) Patentinhaber: Physik Instrumente (PI) GmbH & Co. KG, 76228 Karlsruhe (DE)
(72) Erfinder: Marth, Harry, 76337 Waldbronn (DE)
(74) Vertreter: Meissner, Bolte & Partner

(56) Entgegenhaltungen:
- DE-A1- 19 715 226
- US-A- 5 027 027
- US-A- 6 150 750

## Beschreibung

Die Erfindung betrifft ein Verfahren zum Betreiben eines Piezolinearantriebes gemäß Oberbegriff des Patentanspruches 1.

Multilayer-Stapelaktoren aus piezokeramischen Materialien sind seit vielen Jahren Stand der Technik.
Bei piezoelektrischen Antrieben wird elektrische Energie in Bewegung umgesetzt, indem der elektrostriktive Effekt eines oder mehrerer piezoelektrischen Elemente ausgenutzt wird. Bei einem piezoelektrischem Antrieb, der den longitidunalen Elektrostriktionseffekt ausnutzt, ist der Betrag der Verschiebung pro Einheitslänge des Aktors im Wesentlichen proportional der Intensität des angelegten Feldes. Für eine hohe Auslenkung ist es notwendig, eine große Spannung zwischen den im Regelfall gegenüberliegenden Elektroden anzulegen oder aber es muß der Abstand zwischen den Elektroden verringert werden.

Zur Verstärkung des piezoelektrischen Effektes sind monolithische Vielschichtaktoren zum Stand der Technik gehörend, die aus einem gesinterten Stapel dünner Folien aus Piezokeramik, z.B. Bleizirkonattitanat mit eingelagerten metallischen Innenelektroden bestehen. Die Innenelektroden sind wechselseitig aus dem Stapel herausgeführt und über Außenelektroden elektrisch verschalten. Legt man eine elektrische Spannung an die Außenelektroden an, so dehnen sich die Piezofolien in Feldrichtung aus. Durch die mechanische Serienschaltung der einzelnen Piezofolien wird die Nenndehnung der gesamten Piezokeramik schon bei geringeren elektrischen Spannungen erreicht. Derartige Vielschichtaktoren sind beispielsweise aus der DE 4036287 C2 bekannt.

Darüber hinaus gehören sogenannte Mikromotoren zur Bewegung eines Körpers, wie z.B. in der EP 633616 A2 offenbart zum Bekannten. Derartige Motoren umfassen mindestens eine piezoelektrische Platte, wobei auf den Plattenflächen Elektroden angebracht sind. Auftretende Biegekräfte werden mit Hilfe eines Abstandteiles, das im Schwingungsknoten auf der piezoelektrischen Platte befindlich ist, auf einen Läufer übertragen.

Insbesondere bei Justage- und Positioniereinrichtungen, z.B. für optische Komponenten, sind vielfach Bewegungen in beliebigen Freiheitsgraden erforderlich, wobei eine außerordentlich hohe Positioniergenauigkeit und hohe Haltekräfte erreicht werden müssen.

Setzt man hierfür Piezoaktoren, die im d₃₃-Modus (elektrisches Feld und Auslenkung parallel zur Polarisationsrichtung) arbeiten, dann können zwar relativ große Längenänderungen erreicht werden, jedoch ist es problematisch größere Stellwege von mehreren hundert Mikrometern zu realisieren.

Aus der US-PS 6,150,750 ist ein piezoelektrischer Linear-Schrittmotor bekannt, wobei dort auf eine Anordnung zurückgegriffen wird, welche Aktoren aufweist, die eine auf einem gemeinsamen Substrat befindliche Hybridanordnung darstellen. Innerhalb einer zylindrischen Stapelanordnung ist ein erstes Stapelteil als longitudinal- und ein zweites Stapelteil als Scheraktor ausgebildet. Die verwendeten monolithischen Keramiken mit Isolationsschicht erfordern relativ hohe Betriebsspannungen mit der Folge eines reduzierten Gesamtwirkungsgrades. Auch ist bei der gezeigten Ausführungsform gemäß Stand der Technik das relativ schnelle Heranfahren an eine Grundposition mit anschließender zeitaufgelöster Feinpositionierung nicht möglich.

Aus dem Vorgenannten ist es daher Aufgabe der Erfindung ein Verfahren zum Betreiben eines Piezolinearantriebes mit einer Gruppe von Piezostapelaktoren, welche einen in einer Führung befindlichen Läufer antreiben, zu schaffen, wobei der Antrieb in der Lage sein soll einerseits in kurzer Zeit große Stellwege zurückzulegen andererseits aber auch am oder in der Nähe des Zielpunktes Feinpositionierungen hoher Genauigkeit ermöglicht. Weiterhin soll der Antrieb über die notwendige Steifigkeit verfügen und große Haltekräfte unabhängig von der jeweiligen Lage im Raum gewährleisten.

Die Lösung der Aufgabe der Erfindung erfolgt mit der Lehre nach Patentanspruch 1, wobei die Unteransprüche mindestens zweckmäßige Ausgestaltungen und Weiterbildungen umfassen.

Ein erster Grundgedanke der Erfindung besteht darin, daß mehrere spezielle Hybridaktoren aus Mehrschichtkeramik auf einem gemeinsamen Substrat befindlich sind, wobei innerhalb eines Stapels eines solchen Aktors vom Substrat ausgehend ein erstes Stapelteil als Longitudinal - und ein zweites Stapelteil als Scheraktor ausgebildet ist. Letzteres Stapelteil ist mit einer verschleißfesten Endscheibe, vorzugsweise aus Keramik versehen, welche in Klemm- und/oder Scherkontakt mit dem Läufer steht.

Mindestens zwei derartige, identische Aktoren sind nebeneinander befindlich, um im Schrittbetrieb wechselseitige Klemm- und Vorschubbewegungen bezogen auf den Läufer auszuführen.
In einer bevorzugten Ausführungsform der Erfindung sind mindestens je zwei Aktoren bezogen auf den Läufer jeweils gegenüberliegend angeordnet, um gegenphasige, wechselseitige Klemm- und Vorschubbewegungen auszuführen.

Ein bevorzugtes Antriebsmodul besitzt 4, 6, 8 bis n(n = eine ganze Zahl) Aktoren, wobei zur Lastaufteilung jeweils die ungeradzahligen und die geradzahligen Aktoren untereinander parallel geschalten sind.

Zwischen den auf dem gemeinsamen Substrat befindlichen Aktoren ist ein auf die Scherbewegungen abgestimmter Spalt bzw. Abstand vorhanden. Durch Einsatz von Mehrschichtkeramiken wird die maximale Betriebsspannung bzw. die elektrische Feldstärke so reduziert, daß keine zusätzlichen Isolationsschichten notwendig sind.

Hinsichtlich des Verfahrens zum Betreiben des vorstehend kurz beschriebenen Piezolinearantriebes wird für eine Grobpositionierung der Antrieb im Schrittmodus aktiviert, wobei hierfür die benachbarten und/oder gegenüberliegenden Aktoren wechselseitig oder wechselseitig gegenphasig die gewünschten Klemmungen und Vorschubbewegungen ausführen. Die Steuerspannungen werden über einen entsprechenden Generator in der gewünschten Puls- bzw. Schrittweite bereitgestellt.

Für die Feinpositionierung sind alle zweiten Stapelteile der Aktoren parallelgeschalten und werden analog angesteuert, so daß im Bereich um die momentane Mittellage bei wesentlich geringerer Spannung im Vergleich zum Schrittbetrieb die exakte Zielposition des Läufers einstellbar ist.

Im energielosen oder Analogmodus befinden sich sämtliche ersten Stapelteile in Klemmung, um die gewünschten Haltekräfte und Steifigkeiten zu schaffen.

Gemäß einem zweiten Grundgedanken der Erfindung sind die Aktoren in einer Array- oder Quadrantenanordnung von mindestens vier Stapeln ausgebildet, wobei jeweils die diagonal gegenüberliegenden Stapel eines Aktors parallel angesteuert werden.
Bei dieser Ausführungsform besteht die Möglichkeit neben dem ersten und dem zweiten Stapelteil ein drittes Stapelteil als weiteren Scheraktor auszubilden, wobei die Bewegungsrichtung in dem zweiten und dem dritten Stapelteil, d.h. den beiden Scheraktoren um 90° versetzt ist. Auf diese Weise können unterschiedliche Bewegungsrichtungen des zugeordneten Läufers realisiert werden.

Bei einem dritten Grundgedanken der Erfindung wird von je mindestens einem Aktor ausgegangen, die bezogen auf den Läufer jeweils gegenüberliegend, diesen antreibend angeordnet sind. Jeder der Aktoren besitzt einen symmetrischen Aufbau und umfaßt elektrisch parallel geschaltete Außenabschnitte sowie mindestens einen Innenabschnitt. Die Trennspalte zwischen den Abschnitten verlaufen parallel und sind in Längsrichtung des Läufers orientiert.
Bei dieser vorteilhaften Variante der Erfindung entstehen keine unerwünschten Schwingungskräfte, die sich auf den Läufer und die angetriebene Vorrichtung übertragen und die vom Umgreifen beim Übergang zwischen Scher- und Klemmung ausgelöst werden. Die Parallelorientierung der Aktoren bezogen auf die Längsrichtung des Läufers, wobei der Läufer wiederum bevorzugt symmetrisch zur Symmetrieachse der Aktoren angeordnet ist, bewirkt eine über eine größere, quasi ungestörte Fläche mögliche Krafteinwirkung mit entsprechendem kontinuierlichen Übergang zwischen den Bewegungsschritten.

Die Arbeitsweise eines solchen Antriebes kann wie folgt beschrieben werden. Die bezogen auf den Läufer gegenüberliegenden Aktoren besitzen die erwähnten parallel geschalteten Außenabschnitte. Beim Ansteuern der Außenabschnitte werden die Scheraktoren in gleiche Richtung aktiv und der Läufer bewegt sich durch außen angreifende Kräfte um den vorgegebenen Scherbetrag in seine Längsrichtung. Im Anschluß werden die gegenüberliegenden Innenabschnitte aktiviert. Die Scherkräfte der Innenabschnitte sind bezogen auf diejenigen der Außenabschnitte in entgegengesetzte Richtung verlaufend. Ein Überschwingen kann hierbei wirksam vermieden werden.

Bei einer weiteren Ausführungsform, welche prinzipiell alle bereits erwähnten Eigenschaften in sich vereinigt, ist die Anordnung der Aktoren mit einer einheitlichen Zweipolverdrahtung versehen. Hierzu dient eine zwischen den Stapelteilen verlaufende, die Trennspalte zwischen den Aktoren überbrückende Elektrodenanordnung. Die Aktoren sind in dieser Ausführungsform abwechselnd entsprechend der auszuführenden Klemm- und Vorschubbewegungen parallel bzw. antiparallel zur Polarisationsrichtung der Elektrode gestapelt. Diese Ausführungsform erlaubt es, die Gesamtheit der Piezostapelaktoren geschlossen anzusteuern und zu beschalten.

Vorteilhafterweise wird die durchgängige Elektrodenanordnung als eine Gesamtheit zwischen den Stapelteilen verlaufender durchgängiger Folien gebildet, welche am Ort der zwischen den Aktoren gelegenen Trennspalte Verbindungsstege für eine Anpassung einer Biegesteifigkeit der Folien aufweisen. Dadurch wird ein nachteiliger Einfluß der Elektrodenanordnung auf die ausgeführten Klemm- und Vorschubbewegungen minimiert.

In einer weiteren zweckmäßigen Fortbildung dieser Ausführungsform weist die Elektrodenanordnung an einem ersten und an einem letzten durch diese verbundenen Aktor eine durchgängige Verdrahtung auf, die zu einem Steuergenerator führt.

Entsprechend dieser Ausführungsform reduzieren sich die Anzahl der Steuerleitungen und der Steuergeneratoren erheblich. Die Aktorenanordnung in der Zweipolverdrahtung wird mindestens hinsichtlich der Klemmbewegung der Aktoren durch einen Generator allein mit einem einheitlichen Steuersignal angesteuert.

Die Erfindung soll nachstehend anhand eines Ausführungsbeispieles sowie unter Zuhilfenahme von Zeichnungen näher erläutert werden.

Hierbei zeigen:
- Figur 1: eine Prinzipdarstellung eines Antriebsmoduls für den Piezoli nearantrieb;
- Figur 2: beispielhafte Betriebsspannungsverläufe am Piezolinearmotor;
- Figur 3: einen realisierten Piezolinearantrieb mit zwei gegenüberliegen den Antriebsmodulen und Linearführung;
- Figur 4: einen Piezolinearantrieb in Array-Anordnung der Aktoren
- Figur 5: einen Antrieb ähnlich Figur 4 jedoch mit einem dritten Stapelteil als weiteren Scheraktor und
- Figur 6: einen Antrieb mit parallel geschalteten Außenabschnitt sowie Innenabschnitt.
- Figur 7: eine Aktorenanordnung für einen Piezolinearantrieb ähnlich Figur 1, jedoch in einer Zweipolverdrahtung mittels einer durch- gängigen Elektrodenanordnung
- Figur 8: eine beispielhafte Darstellung einer durchgehenden Folie als Bestandteil der Elektrodenanordnung aus Figur 7.

Der Piezolinearantrieb gemäß Ausführungsbeispiel stellt ein Hybridsystem dar. Konkret wird der Linearantrieb in zwei Modi realisiert. Über einen Schrittmodus erfolgt eine grobe Annäherung an die Zielposition. Die eingesetzten Piezoaktoren lassen sich in Klemm- und Vortriebspiezos unterscheiden, die alternierend angesteuert werden.

Die Schrittweite dieser Piezos ist einstellbar und liegt beispielsweise im Bereich von 0,1 bis 2 µm. Nach Annäherung an die Zielposition werden die Klemmpiezos in einen elektrisch spannungslosen Zustand überführt, wobei hier der Läufer geklemmt bleibt.

Eine Feinpositionierung im Analogmodus erfolgt dann ausschließlich durch die Vortriebspiezos, die einen Verstellbereich von im wesentlichen von 2 µm realisieren können und welche symmetrisch um die Mittellage arbeiten. Im Analogmodus liegt die nominal zulässige Feldstärke der Vorschubpiezos nur bei maximal 25 Prozent der Feldstärke (500 V/mm), die bei d₃₃-Aktoren an Luft verwendet wird (2000 V/mm). Bei einer Annäherung an die Zielposition über den Schrittmodus auf 0,1 µm, werden die Vorschubpiezos beim Umschalten in den Analogmodus mit lediglich 1 bis 2 Prozent der nominalen Feldstärke an Luft betrieben, was für die Langzeitstabilität der Anordnung von wesentlichem Vorteil ist.

Ergeben sich größere Abweichungen als solche, die der Analogstellbereich abdeckt, oder sind die benötigten Betriebsfeldstärken zu hoch, kann durch Umschalten auf Einzelschrittbetrieb wieder auf die Mittellage eingestellt werden.

Das Hybridsystem gemäß Ausführungsbeispiel gewährleistet Positionierbereiche von mehreren hundert Mikrometern bei einer Auflösung von wenigen Nanometern. Die Belastbarkeit liegt im Bereich von mehreren Kilogramm bei Resonanzfrequenzen von einigen hundert Hertz.
Die Positioniervorgänge lassen sich sehr schnell auslösen und steuern und es wird eine kompakte Bauform erreicht. Die Verlustleistungen sind durch die Betriebsartwahl im Vergleich zu direkten Piezoantrieben oder Piezoaktoren mit integrierter Wegübersetzung geringer. Aufgrund der niedrigen effektiven DC-Feldstärken werden Lebensdauerspezifikationen, wie sie für technologische Spezialausrüstungen gegeben sind, erreicht.

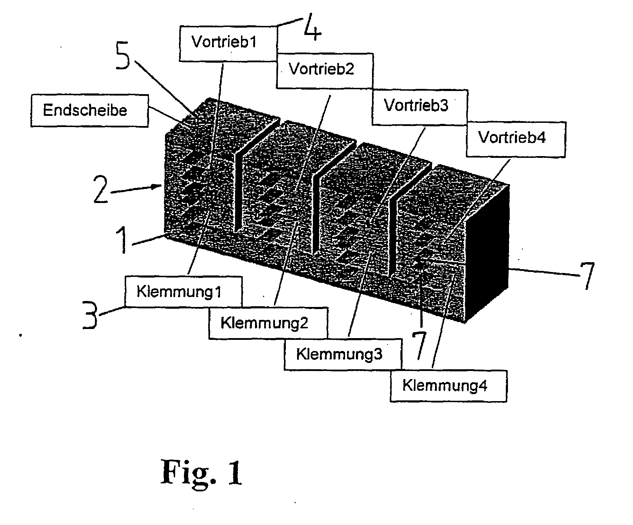

Der in der Figur 1 dargestellte Piezolinearmotor weist auf einem gemeinsamen Substrat 1 befindliche Hybridaktoren 2 auf.
Die Hybridaktoren 2 besitzen ein erstes Stapelteil 3 für die Klemmung sowie ein zweites Stapelteil 4 für die notwendigen Vortriebs- bzw. Scherbewegungen.

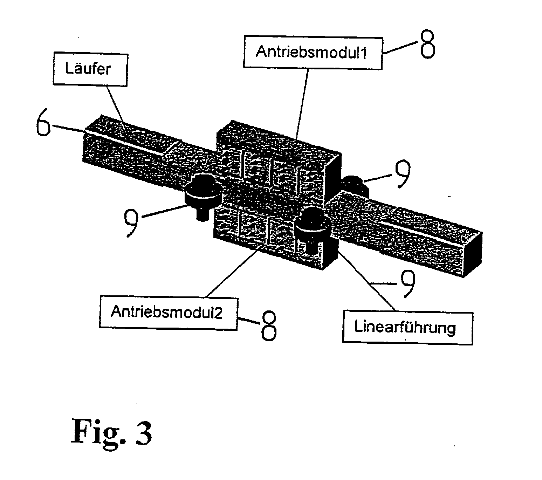

Eine verschleißfeste Endscheibe 5 steht mit einem Läufer 6 (Figur 3) in Verbindung.

Über herausgeführte Elektroden 7 erfolgt das gewünschte elektrische Verschalten der einzelnen Hybridaktoren 2.

Wie dargestellt können beispielsweise vier identische Piezokeramikstapel auf dem gemeinsamen Substrat 1 ausgebildet sein, wobei die Stapel wie beschrieben im Aufbau zweigeteilt sind. Die ersten Stapelteile arbeiten als d₃₃-Aktoren und sind für die vertikale Klemmbewegung senkrecht zur Laufrichtung erforderlich. Der obere, zweite Stapelteil arbeitet im Schermodus in horizontaler Laufrichtung.

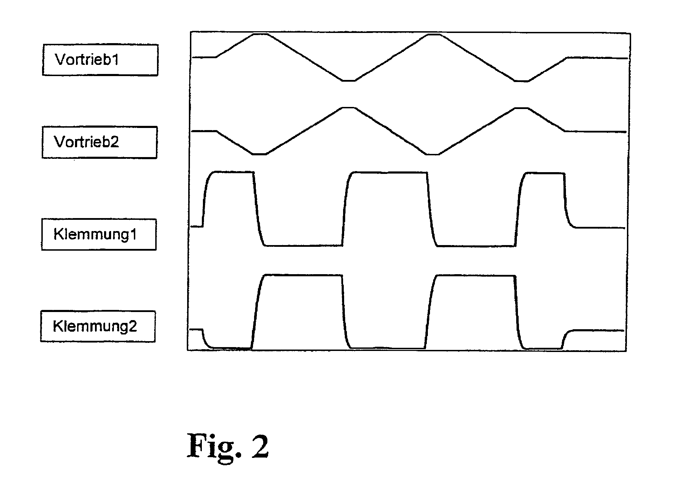

Wie in der Figur 2 dargestellt, erfolgt eine elektrische Ansteuerung aller Aktoren in dem Sinne, daß im Schrittbetrieb alle Endscheiben 5 wechselseitige gegenphasige Andruck- und Vorschubbewegungen ausführen, die eine schrittförmige Verschiebung des angekoppelten Läufers 6 (Figur 3) ergeben. Zur Umkehr der Bewegungsrichtung sind jeweils die Vortriebs- oder Klemmspannungen zu invertieren.

Die dritten und vierten Aktoren sind zur besseren Lastaufteilung mit den ersten und zweiten Aktoren parallel geschalten.

Wie aus der Darstellung des Betriebsspannungsverlaufes am Piezolinearmotor nach Figur 2 zu erkennen, sind zu jeder Zeit im Schrittmodus minimal zwei Klemmungen geschlossen, so daß auch bei Vertikalbetrieb kein Durchrutschen des Läufers 6 eintreten kann. Dies gilt ebenso für den energielosen Zustand und den Analogmodus, in welchem alle vier Klemmungen geschlossen sind und wobei die größte Haltkraft und Steifigkeit der Gesamtanordnung erreicht wird.

Im Analogmodus arbeiten alle Vortriebspiezos, d.h. die zweiten Stapelteile parallel und verhalten sich wie ein bekanner PZT-Stapel mit geringem Stellweg von einigen Mikrometern.

Figur 3 zeigt eine Ausführungsform eines Piezolinearantriebes mit zwei parallel geschalteten Antriebsmodulen 8 zur Erhöhung der Stellkräfte.

Die Antriebsmodule 8 werden durch eine symmetrische Vorlast von unten und oben an den in der Mitte befindlichen Läufer 6 angepreßt und sind in Stellrichtung über die durchgehenden Substrate 1 möglichst steif mit einem nicht gezeigten Gehäuse verbunden. Eine Linearführung 9 ermöglicht dann bei Aktivieren der Antriebsmodule 8 die gewünschte Bewegung des Läufers 6.

Beispielhafte Antriebsmodule 8 besitzen eine Größe von 5 x 5 x 20 mm², wobei sich Stellwege im Bereich von 10 mm bei einer Schrittweite von maximal 2 µm und minimal von 50 bis 100 nm erreichen lassen. Der Stellweg im analogen Modus liegt im Bereich von 2,5 µm mit einer Auflösung von < 0,1 nm in Abhängigkeit vom Signal-Rausch-Verhältnis der jeweiligen Ansteuerelektronik.

Es liegt im Sinne der Erfindung, daß nicht nur wie im Ausführungsbeispiel gezeigt Läufer mit quadratischem oder rechteckigem Querschnitt Anwendung finden können, sondern auch solche in einer Kreis- oder Ellipsenform, wobei dann im entsprechenden Sinne die Endscheiben, die als Reibungs- und Kraftübertragungselemente wirken, anzupassen sind.
Auch können die Antriebsmodule nicht nur vier sondern größere Gruppen von 6, 8 oder n Aktoren umfassen. Bei einem kreisbogenförmigen Läufer für rotierende Antriebe ist dann das gemeinsame Substrat des jeweiligen Antriebsmoduls und dieser der Läuferkreisbogenform angepaßt.

Bei der gewählten Konstruktion erfolgt die Ansteuerung im Schrittmodus derart, daß die Reibflächen am Aktor und Läufer keine Relativbewegungen zueinander ausführen, wenn diese unter hohem Anpressdruck stehen. Ein Bewegen der Vortriebsaktoren erfolgt ausschließlich im abgehobenen Zustand, so daß der Verschleiß zwischen den sich gegenüberliegenden Flächen minimiert werden kann.

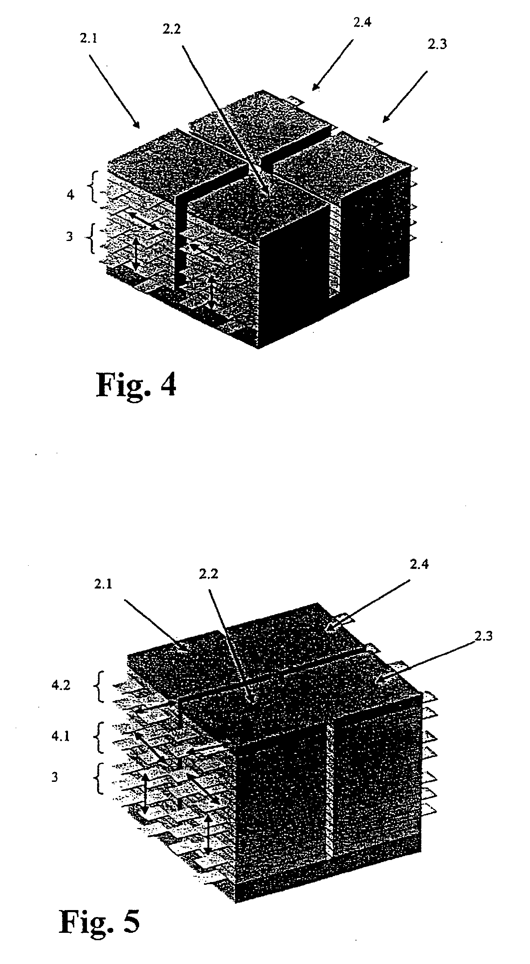

Figur 4 zeigt eine Ausführungsform des Piezolinearantriebes in einer Array- oder Quadrantenanordnung der Aktoren. Hier sind mindestens vier Stapel ausgebildet, wobei jeweils die diagonal gegenüberliegenden Stapel eines Aktors, d.h. 2.1 mit 2.3 und 2.2 mit 2.4 parallel angesteuert werden.

Nach Figur 5 besteht die Möglichkeit innerhalb jedes Stapels neben dem ersten Stapelteil 3 für die Klemmung und dem zweiten Stapelteil 4.1 ein drittes Stapelteil 4.2 vorzusehen, welches als weiterer Scheraktor wirkt. Dieser weitere Scheraktor 4.2 besitzt eine Bewegungsrichtung, die zu derjenigen des zweiten Stapelteiles 4.1 um 90° versetzt ist, so daß mehrere Bewegungsfreiheitsgrade eines angetriebenen Läufers erreicht werden können.

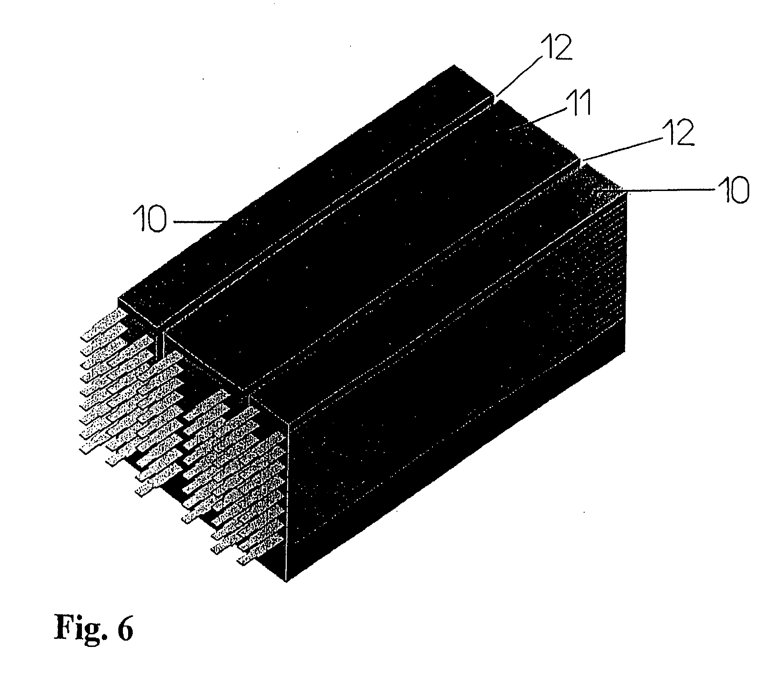

Einen grundsätzlich andersartigen Aufbau der Aktoren, die allerdings auch aus Mehrschichtkeramiken bestehen, weist der Piezolinearantrieb nach Figur 6 auf. Die dortigen Aktoren besitzen einen symmetrischen Aufbau mit elektrisch parallel geschalteten Außenabschnitten 10 sowie mindestens einem Innenabschnitt 11. Die Trennspalte 12 verlaufen hier parallel zur Längsachse, d.h. in Bewegungsrichtung des (nicht gezeigten) Läufers. Wird ein Läufer mit zwei derartigen gegenüberliegenden Aktoren analog wie in Figur 3 dargestellt angetrieben, dann wirken die abwechselnden Klemm- und Scherkräfte sehr gleichmäßig, was zu einer quasi kontinuierlichen schwingungsfreien Bewegung führt, so daß die Eigenschaften des Antriebes insgesamt verbessert sind.

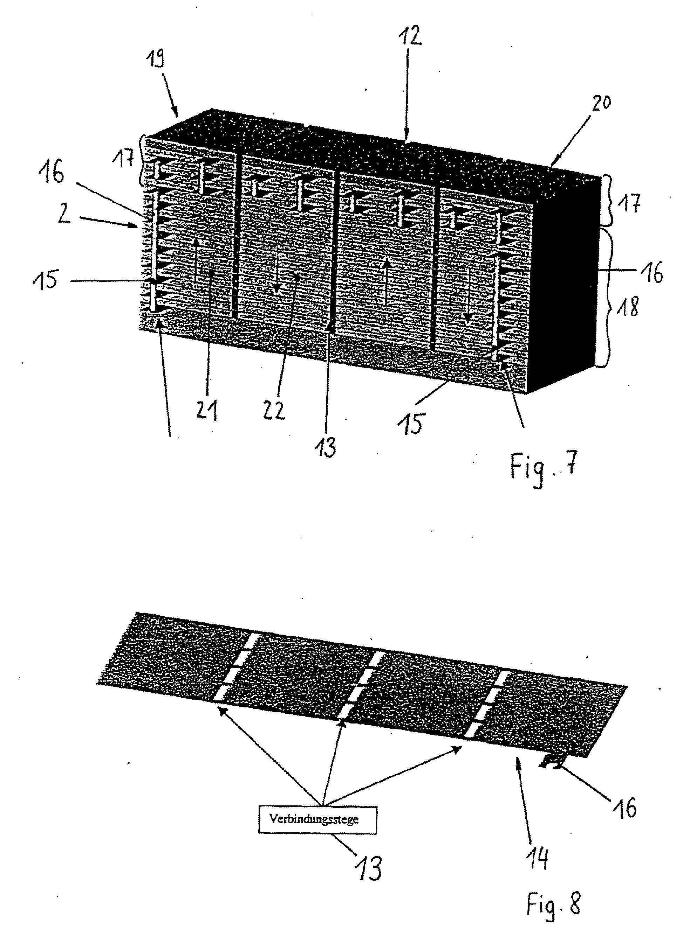

Eine hinsichtlich der Ansteuerung sowie der Verdrahtung der Aktoren verbesserte Ausführungsform ist in den Figuren 7 und 8 beispielhaft an einer linearen Anordnung von Piezoaktoren dargestellt. Fig. 7 zeigt eine Möglichkeit, die gesamte Aktorenanordnung hinsichtlich ihrer Klemmbewegungen durch eine Zweipolverdrahtung anzusteuern. Die Hybridaktoren 2 sind durchgängig in einem unteren Teilbereich durch eine Reihe von die Trennspalte 12 überbrückende leitfähige und mit Verbindungsstegen 13 versehene Folien 14 miteinander verbunden, die zwischen die zur Klemmung dienenden ersten Stapelteile 3 eingeschoben sind. Die Ausgestaltung der Folien 14 ermöglicht eine durchgängige Verdrahtung 15 über Kontaktstellen 16 an einem ersten Aktor 19 und einem zweiten Aktor 20. Innerhalb eines Vortriebsabschnittes 17 werden die Hybridaktoren 2 zu bereits erwähnten linear treibenden Scherbewegungen mittels einer bereits beschriebenen Elektrodenanordnung angeregt.

In einem Klemmungsabschnitt 18 wird mittels der durchgehenden Folien 14 eine Klemmbewegung der Aktoren hervorgerufen. Die Aktoren sind innerhalb des Klemmungsabschnittes so gestapelt, dass innerhalb eines ersten Aktors bei einer parallelen Stapelanordnung 21 die Stapelteile in paralleler Richtung zu einer von außen angelegten Polarisationsrichtung gestapelt sind, während bei einer antiparallelen Stapelanordnung 22 die Stapelteile antiparallel zur Polarisationsrichtung orientiert sind. Ein zwischen den durchgehenden Folien 14 anliegendes elektrisches Feld verursacht eine Verlängerung bzw. Verkürzung des zugehörigen Aktors im Klemmungsbereich, wobei die gesamte Aktorenanordnung einheitlich mittels der Verdrahtungen 15 angesteuert wird. Die Klemmbewegung der Aktorenanordnung wird somit mit nur einem Generator erzeugt, wodurch sich gesamte Generatorenzahl bei dem in Fig. 7 gezeigten Anwendungsbeispiel von 4 auf 3 gegenüber den vorher genannten Anwendungsbeispielen reduziert. Des weiteren verringert sich die notwendige äußere Verdrahtung in diesem Beispiel von 8 auf 3. Versuche haben ergeben, dass bei einer solchen, in Fig. 7 gezeigten Aktorenanordnung eine Reduzierung benötigter Kontakte und interner Lötstellen von 88 auf 37 erfolgen kann, was einen beträchtlichen Vorteil bei der Fertigung eines solchen Linearantriebs mit sich bringt. Zusätzlich dazu erhöht sich die Materialsteifigkeit des Piezoantriebs.

Die durchgängigen Folien 14 können die gegenläufigen Bewegungen während der ausgeführten Klemmbewegungen wegen ihrer geringen Dicke ohne weiteres kompensieren. Zusätzlich besteht jedoch die Möglichkeit, durch eine in Fig. 8 dargestellte Anordnung aus Verbindungsstegen 13, die optional in die Folie 14 eingebracht werden können, die mechanischen Eigenschaften der Folien 14 im Bereich der Trennspalte 12 der Bewegung der Aktoren anzupassen.

### Bezugszeichenliste

- 1: Substrat
- 2: Hybridaktoren
- 3: erstes Stapelteil
- 4: zweites Stapelteil
- 5: Endscheibe
- 6: Läufer
- 7: Elektroden
- 8: Antriebsmodul
- 9: Linearführung
- 10: Außenabschnitt
- 11: Innenabschnitt
- 12: Trennspalt
- 13: Verbindungsstege
- 14: Folie
- 15: Verdrahtung
- 16: Kontaktstelle
- 17: Vortriebsabschnitt
- 18: Klemmungsabschnitt
- 19: Erster Aktor
- 20: Zweiter Aktor
- 21: Parallele Stapelanordnung
- 22: Antiparallele Stapelanordnung

## Patentansprüche

1. Verfahren zum Betreiben eines Piezolinearantriebs mit einer Gruppe von Piezostapelaktoren, welche einen in einer Führung befindlichen Läufer (6) antreiben, und die Aktoren (2) eine auf einem gemeinsamen Substrat (1) befindliche Mehrschichtkeramik-Hybridanordnung darstellen, innerhalb eines Stapels ausgehend vom Substrat ein erstes Stapelteil (3) als Longitudinal - und ein zweites Stapelteil (4) als Scheraktor ausgebildet sowie letzteres mit einer verschleißfesten Endscheibe (5) versehen ist, welche in Klemm- und/ oder Scherkontakt mit dem Läufer (6) steht, wobei mindestens zwei identische Aktoren (2) nebeneinander befindlich sind, um im Schrittbetrieb wechselseitige Klemm- und Vorschubbewegungen auszuführen
**dadurch gekennzeichnet, dass**
für eine Grobpositionierung der Antrieb im Schrittmodus erfolgt, und hierfür die benachbarten Aktoren (2) zur Ausführung wechselseitiger oder gegenphasig wechselseitiger Klemm- und Vorschubbewegungen elektrisch angesteuert werden, sowie für die Feinpositionierung alle zweiten Stapelteile (4) der Aktoren (2) parallel geschaltet und analog angesteuert werden, so dass im Bereich um die jeweilige momentane Mittellage bei wesentlich verringerter Spannung und Feldstärke die Zielposition des Läufers (6) einstellbar ist.

2. Verfahren nach Anspruch 1,
**dadurch gekennzeichnet, dass**
der Piezolinearantrieb mindestens je zwei bezogen auf den Läufer (6) gegenüberliegend angeordnete Aktoren aufweist.

3. Verfahren nach Anspruch 1 oder 2,
**dadurch gekennzeichnet, dass**
ein Antriebsmodul (8) 4, 6, 8 bis n (n = ganze Zahl) Aktoren (2) aufweist, wobei zur Lastaufteilung jeweils die ungeradzahligen und die geradzahligen Aktoren (2) untereinander parallel geschaltet werden.

4. Verfahren nach einem der vorhergehenden Ansprüche,
**dadurch gekennzeichnet, dass**
zwischen den auf dem gemeinsamen Substrat (1) befindlichen Aktoren (2) ein auf die Scherbewegung abgestimmter Spalt (12) vorgesehen ist.

5. Verfahren nach einem der vorhergehenden Ansprüche,
**dadurch gekennzeichnet, dass**
im energielosen Zustand oder Analogmodus sämtliche erste Stapelteile (3) sich auf Klemmung befinden, um die gewünschten Haltekräfte und Steifigkeiten zu erreichen.

## Claims

1. Method for operating a piezo linear drive with a group of piezo stack actuators configured to drive a moving member (6) located in a guidance device, wherein the actuators (2) represent a multi-layer ceramics hybrid arrangement located on a common substrate (1), wherein within a stack extending from the substrate a first stack part (3) is configured as a longitudinal actuator and a second stack part (4) is configured as a shearing actuator and the second stack part is equipped with a wear-resistant end plate (5) which is in a clamping contact and/or shearing contact with the moving member (6), wherein at least two identical actuators (2) are located adjacent to each other in order to perform alternating clamping and advancing movements during the stepping operation,
**characterized in that**
for rough positioning the drive occurs in a stepping mode, for which purpose the adjacent actuators (2) are electrically driven so as to perform alternating or alternating phase opposition clamping and advancing movements, and for the fine positioning all second stack parts (4) of the actuators (2) are connected in parallel and are driven in an analog mode so that in the area around the respective current central position the target position of the moving member (6) can be adjusted at a substantially reduced voltage and field strength.

2. Method according to claim 1,
**characterized in that**
the piezo linear drive comprises at least two actuators arranged oppositely with respect to the moving member (6).

3. Method according to claim 1 or 2,
**characterized in that**
a driving module (8) includes 4, 6, 8 to n (n = integer) actuators (2), wherein for the purpose of load distribution the odd-numbered and even-numbered actuators, respectively, are interconnected in parallel.

4. Method according to one of the preceding claims,
**characterized in that**
a distance (12) that is adjusted to the shearing movement is provided between the actuators (2) located on the common substrate (1).

5. Method according to one of the preceding claims,
**characterized in that**
in the energy-less state or the analog mode, all first stack parts (3) are in the clamping mode in order to achieve the desired retaining forces and stiffnesses.

## Revendications

1. Procédé pour le fonctionnement d'un entraînement linéaire piézo-électrique comprenant un groupe d'actionneurs piézo-électriques empilés, qui entraînent un élément mobile (6) disposé dans un guidage, et les actionneurs (2) représentent un agencement hybride céramique multicouches qui se trouve sur un substrat commun (1) dans lequel à l'intérieur d'un empilement et en partant du substrat, une première partie d'empilement (3) est réalisée sous forme d'actionneur longitudinal et une seconde partie d'empilement (4) est réalisée sous forme d'actionneur de cisaillement, ce dernier étant pourvu d'une plaque terminale (5) résistante à l'usure, qui se trouve en contact de serrage et/ou de cisaillement avec l'élément mobile (6), et au moins deux actionneurs identiques (2) se trouvent l'un à côté de l'autre, afin d'exécuter en mode pas à pas des déplacements alternants de serrage et d'avance,
**caractérisé en ce que**
pour un positionnement grossier l'entraînement a lieu en mode pas à pas, et à cet effet les actionneurs voisins (2) sont pilotés par voie électrique pour exécuter des mouvements alternants en phase ou en opposition de phase de serrage et d'avance, et pour un positionnement fin, toutes les parties d'empilement (4) des actionneurs (2) sont commutées en parallèle et pilotées par voie analogique, de sorte que dans la région autour de la position centrale momentanée respective il est possible de régler la position cible de l'élément mobile (6) avec une tension et une intensité de champ sensiblement réduites.

2. Procédé selon la revendication 1,
**caractérisé en ce que** l'entraînement linéaire piézo-électrique comprend au moins deux actionneurs agencés respectivement en opposition par référence à l'élément mobile (6).

3. Procédé selon la revendication 1 ou 2,
**caractérisé en ce qu'**un module d'entraînement (8) comprend 4, 6, 8 à n (n étant un nombre entier) actionneurs (2), et pour la répartition des charges, les actionneurs (2) de numéros impairs et les actionneurs de numéros pairs sont branchés respectivement parallèlement les uns aux autres.

4. Procédé selon l'une des revendications précédentes,
**caractérisé en ce qu'**un intervalle (12) ajusté aux mouvements de cisaillement est prévu entre les actionneurs (2) qui se trouvent sur le substrat commun (1).

5. Procédé selon l'une des revendications précédentes,
**caractérisé en ce que** dans l'état sans énergie, ou dans le mode analogique, la totalité des premières parties d'empilement (3) se trouvent en situation de serrage pour atteindre la force de maintien et les raideurs souhaitées.
